# EUROPEAN PATENT SPECIFICATION

(11) **EP 0 638 938 B1**
(45) Date of publication and mention of the grant of the patent: **25.02.1998**
(21) Application number: 94202274.0
(22) Date of filing: 08.08.1994
(51) Int. Cl.: H01L 29/78, H01L 29/786, H01L 29/06, H01L 29/739, H01L 21/336

(54) **SOI transistor**
SOI-Transistor
Transistor SOI

(30) Priority: 10.08.1993 US 105213
(43) Date of publication of application: 15.02.1995
(73) Proprietor: PHILIPS ELECTRONICS N.V., 5621 BA Eindhoven (NL)
(72) Inventor: Merchant, Steven L., c/o Int.Octrooibureau B.V., NL-5656 AA Eindhoven (NL)
(74) Representative: Veerman, Jan Willem

(56) References cited:
- EP-A- 0 549 042
- PATENT ABSTRACTS OF JAPAN vol. 15, no. 323 (E-1101) 16 August 1991 & JP-A-03 119 733 (FUJITSU LTD) 22 May 1991
- PATENT ABSTRACTS OF JAPAN vol. 6, no. 67 (E-104) 28 April 1982 & JP-A-57 010 266 (FUJITSU LTD) 19 January 1982
- PATENT ABSTRACTS OF JAPAN vol. 8, no. 190 (E-263) 31 August 1984 & JP-A-59 078 557 (TOSHIBA KK) 7 May 1984

## Description

The invention relates to a thin film SOI device, comprising a buried insulating layer; a layer of silicon on said buried insulating layer; an upper insulating layer on said layer of silicon; said layer of silicon having a laterally extending drift region, a gate region with a gate electrode above a gate oxide above said gate region at one end of the drift region, a drain region at an opposite end of the drift region and a source region laterally separated from said gate region. The invention also relates to a method of manufacturing such an SOI device.

Such a device is known from European patent application 549042 and sketched in Figure 1. A major problem in high voltage integrated circuit technology is to find a satisfactory solution for the problem of isolation of components and sub-circuit sections. In the known device the drift region 4 of a SOI transistor is provided as a thin layer of silicon having a thickness of about 200 to 300 nanometres. In this device the insulating layers are of oxide. The upper oxide layer 6 on the silicon layer preferably has the same thickness as the buried oxide layer 2 below the silicon layer. The benefit of this structure is the ability to deplete the drift region 4 from both the top and bottom so that twice the conducting charge may be placed in the drift region 4. This lowers the on-resistance of the device. In the known device the buried oxide layer 2 has a thickness ranging from 1 to 3 micron, and the upper oxide layer 6 also has a thickness ranging from 1 to 3 micron. For this device a high breakdown voltage ranging from 500 - 900V is achieved where the drift region 4 of the silicon layer 1 is very thin, i.e., 0.1-0.4 micron.

In addition the known device provides the drift region 4 with a linear lateral doping region with the smaller concentration near the gate region. Over the drift region 4 a field plate 7 is provided. On the silicon layer in the gate region 1 there is a thin gate oxide 8 above which the polysilicon gate electrode 13 is located. The lateral extent of the gate electrode overlies the thin lateral linear doping region. The SOI device includes source and drain regions 10 of n⁺ conductivity, respectively adjacent the gate region and drift region. The source region also includes a p⁺ source layer 11 so that the source-contact 12 contacts both source layers 10 and 11. The source region is formed on a p-body 9. Electrical contacts 12 contact each of the source region, drain region and gate electrode 13.

This known structure forms a SOI semiconductor device having a high breakdown voltage characteristic.

The problem with this device, however, is low forward current saturation in the source-high configuration, such as encountered in bridge circuits. When the source is allowed to float to the high potential, the forward current is relatively small.

The present invention seeks to improve this previous structure by preventing this problem.

In order to prevent this problem, the device is characterized in that the drift region comprises both a thicker and a thinner portion.

It seems that during source-high operation the drift region becomes depleted of electrons. The thicker portion opposes the depletion. Preferably the drift region comprises a lateral linear doping region, the thinner portion extends over a length of 1/3 to 2/3 of the length of the drift region, and a field plate is provided on the upper insulating layer, which field plate is short-circuited with the gate electrode and extends over the thinner portion.

When the drift region contains a lateral linear doping region, the dope increases from the gate region towards the drain region. Then the depletion is more pronounced toward the left side of the drift region near the gate region because the doping concentration is smaller there. The thinner portion is then provided adjacent the drain region.

The inventive device provides SOI circuitry that enable the reverse voltage characteristics to remain virtually the same as in the known device, while the forward voltage characteristics in the source-high configuration encountered in a bridge circuit provide only a slight forward current saturation, whereas the forward current in the known device decreases drastically with negative substrate voltage.

The invention will be described in detail, by way of example, with reference to the drawing figures. Therein:
Figure 1 illustrates in-cross-section the known device of European patent application 549042;
Figure 2 illustrates in cross-section the improved device according to the present invention;
Figures 3a and 3b illustrate a comparison of the reverse characteristics of the device of Figure 1 and the inventive device of Figure 2, respectively; and
Figures 4a and 4b show the forward characteristics of the previous device and the present inventive device respectively.

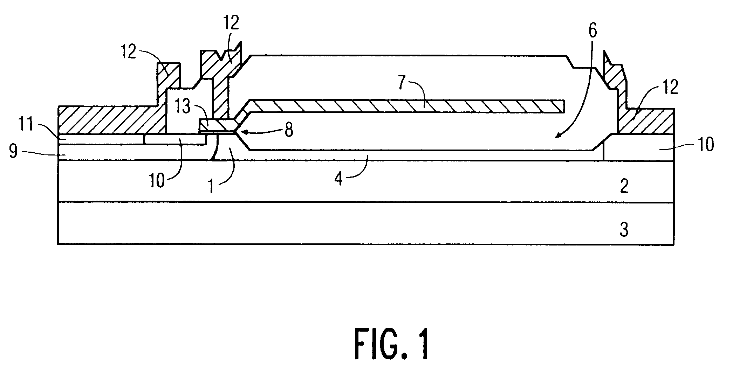

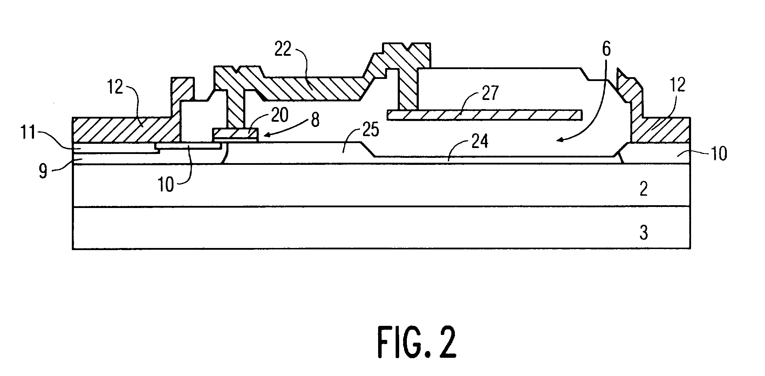

The same reference numerals are maintained in Figure 1 and 2 for the same features.

The device of the present invention presents an improvement of the known device of European patent application 549042. This new device has been fabricated in a manner analogous to the fabrication of the known device as described in EP patent application 549042 and EP patent application 497427, used as prior art in EP application 549042. For further details of the known device and its manufacturing process reference is made to these patent applications.

The inventive device prevents forward current saturation during source-high operation, such as occurs with bridge circuits. This is achieved according to the present invention by thinning the silicon layer 24, 25 in Figure 2 only over a portion 24 of about 1/3 to 2/3 of the length of the drift region providing the lateral linear doping region of the SOI device. The left side portion 25 of the silicon layer remains at a higher thickness, such as about 1 to 2 micron, while the right side portion 24 has been thinned to about 0.1 - 0.4 microns.

The polysilicon gate electrode 20 is also separated from the polysilicon field plate 27. A metal interconnect 22 of a material such as aluminum is used to short-circuit these polysilicon electrode layers, and to act as a metal field plate over the thicker left side portion 25 of the silicon layer. The intermediate upper oxide layer 6 between the portion 24 and the field plate 27 also extends between the metal interconnect 22 and the left portion 25 of the silicon layer at the same thickness as the buried oxide layer 2.

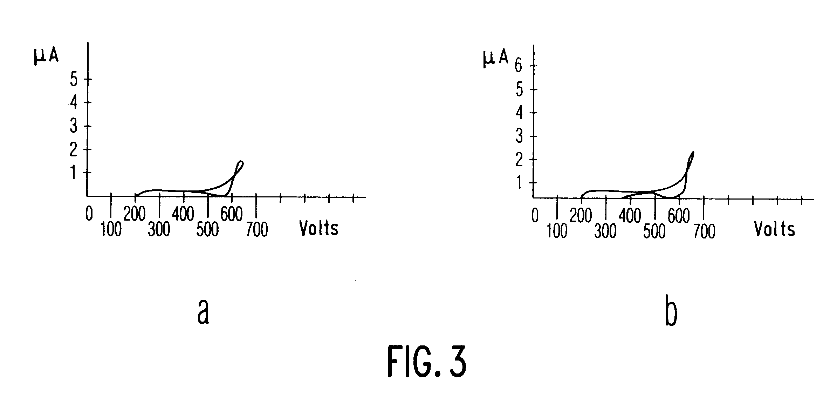

Figures 3a and 3b show the reverse characteristics of a known device as that in Figure 1 and the new device of the present invention shown in Figure 2, respectively. Identical breakdown voltages of about 620 volts were achieved for both devices.

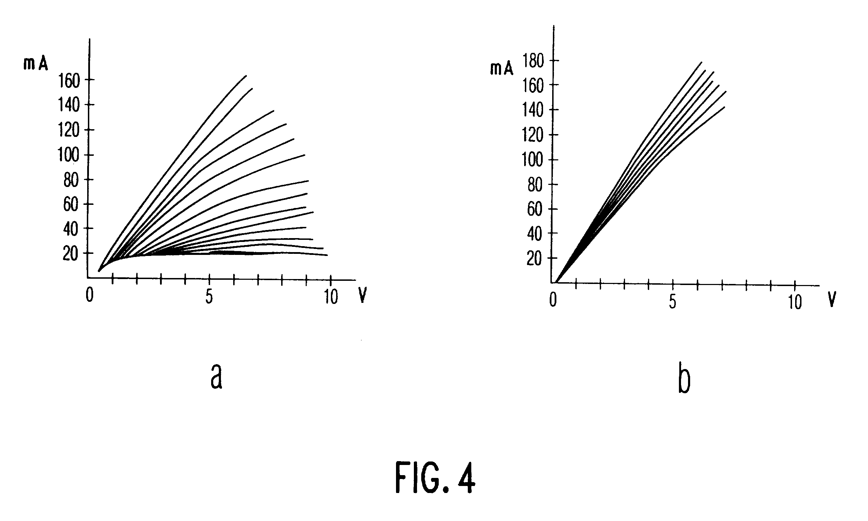

On the other hand, Figures 4a and 4b show the forward characteristics of the previous and present SOI devices, respectively. In both cases, the substrate was biased from 0 to -200 volts in steps of -1 volt. This test is representative of the source-high configuration used in bridge circuits. The forward current in the previous device decreases drastically with negative substrate voltage resulting in a high forward current saturation. The improved structure of the present application provides a device showing only a slight forward current saturation.

As an alternative in the arrangement of the present invention, the n⁺ drain region 10 may be replaced by a thin p⁺ drain in order to make a LIGBT circuit device. In this case, however, the p⁺ drain is then placed on an n buffer layer.

## Claims

1. A thin film SOI device, comprising a buried insulating layer (2); a layer of silicon on said buried insulating layer; an upper insulating layer (6) on said layer of silicon; said layer of silicon having a laterally extending drift region (24, 25), a gate region with a gate electrode (20) above a gate oxide (8) above said gate region at one end of the drift region, a drain region (10) at an opposite end of the drift region and a source region (10) laterally separated from said gate region, characterised in that the drift region comprises both a thicker (25) and a thinner (24) portion.

2. A thin film SOI device according to claim 1, characterized in that the drift region comprises a lateral linear doping region, in that the thinner portion extends over a length of 1/3 to 2/3 of the length of the drift region, and in that a field plate (27) is provided on the upper insulating layer, which field plate is short-circuited with the gate electrode and extends over the thinner portion.

3. A thin film SOI device according to claim 1, characterized in that said thinner portion has a thickness of 0.1 - 0.4µm.

4. A thin film SOI device according to claim 1, characterized in that said layer of silicon has a thickness of about 1 - 2 µm in the drift region adjacent the thinner portion.

5. A method of manufacturing a thin film SOI device according to any of the previous claims comprising the steps of forming a silicon layer on a buried oxide layer on a substrate, thinning a portion of said silicon layer which thinned portion forms part of a drift region, forming an oxide layer over said silicon layer, providing a gate electrode on said silicon layer free of said portion, extending a field plate over said portion on said oxide layer, and short-circuiting said gate electrode and said field plate.

## Patentansprüche

1. SOI-Dünnschichtanordnung, welche eine vergrabene Isolationsschicht (2), eine Siliciumschicht auf der vergrabenen Isolationsschicht, eine obere Isolationsschicht (6) auf der Siliciumschicht, wobei die Siliciumschicht eine sich lateral erstreckende Driftzone (24,25) vorsieht, eine Gatezone mit einer Gateelektrode (20) über einem Gateoxid (8) oberhalb der Gatezone an einem Ende der Driftzone, eine Drainzone (10) an einem entgegengesetzten Ende der Driftzone sowie eine von der Gatezone lateral beabstandete Sourcezone (10) aufweist, dadurch gekennzeichnet, daß die Driftzone sowohl einen dickeren (25) als auch einen dünneren (24) Teil aufweist.

2. SOI-Dünnschichtanordnung nach Anspruch 1, dadurch gekennzeichnet, daß die Driftzone eine laterale, lineare Dotierungszone aufweist, daß der dünnere Teil sich über eine Länge von 1/3 bis 2/3 der Länge der Driftzone erstreckt, und daß auf der oberen Isolationsschicht eine Feldelektrode (27) vorgesehen ist, welche mit der Gateelektrode kurzgeschlossen wird und sich über den dünneren Teil erstreckt.

3. SOI-Dünnschichtanordnung nach Anspruch 1, dadurch gekennzeichnet, daß der dünnere Teil eine Stärke von 0,1 - 0,4µm aufweist.

4. SOI-Dünnschichtanordnung nach Anspruch 1, dadurch gekennzeichnet, daß die Siliciumschicht eine Stärke von etwa 1 - 2 µm in der an den dünneren Teil angrenzenden Driftzone aufweist.

5. Verfahren zur Herstellung einer SOI-Dünnschichtanordnung nach einem der vorangegangenen Ansprüche, wonach eine Siliciumschicht auf einer vergrabenen Oxidschicht auf einem Substrat gebildet wird, die Stärke eines Teiles der Siliciumschicht reduziert wird, wobei dieser einen Teil einer Driftzone bildet, eine Oxidschicht über der Siliciumschicht ausgebildet wird, eine Gateelektrode auf der nicht den reduzierten Teil aufweisenden Siliciumschicht vorgesehen wird, sich eine Feldelektrode über dem Teil auf der Oxidschicht erstreckt und Gateelektrode und Feldelektrode kurzgeschlossen werden.

## Revendications

1. Dispositif SOI à couche mince comprenant une couche isolante enterrée (2); une couche de silicium sur ladite couche isolante enterrée; une couche isolante supérieure (6) sur ladite couche de silicium; ladite couche de silicium ayant une région de migration (24, 25) s'étendant latéralement, une région de grille avec une électrode de grille (20) au-dessus d'un oxyde de grille (8) au-dessus de ladite région de grille à une extrémité de la région de migration, une région de drain (10) à une extrémité opposée de la région de migration et une région de source (10) séparée latéralement de ladite région de grille, caractérisé en ce que la région de migration comprend à la fois une partie plus épaisse (25) et une partie plus mince (24).

2. Dispositif SOI à couche mince selon la revendication 1, caractérisé en ce que la région de migration comprend une région de dopage linéaire latérale, en ce que la partie plus mince s'étend sur une longueur de 1/3 à 2/3 de la longueur de la région de migration et en ce qu'une plaque de champ (27) est appliquée sur la couche isolante supérieure, ladite plaque de champ étant court-circuitée avec l'électrode de grille et s'étendant par-dessus la partie plus mince.

3. Dispositif SOI à couche mince selon la revendication 1, caractérisé en ce que ladite partie plus mince a une épaisseur de 0,1 à 0,4 µm.

4. Dispositif SOI à couche mince selon la revendication 1, caractérisé en ce que ladite couche de silicium a une épaisseur d'environ 1 à 2 µm dans la région de migration adjacente à la partie plus mince.

5. Procédé de fabrication d'un dispositif SOI à couche mince selon l'une quelconque des revendications précédentes, comprenant les étapes consistant à former une couche de silicium sur une couche d'oxyde enterrée sur un substrat, à amincir une partie de ladite couche de silicium, ladite partie amincie faisant partie d'une région de migration, à former une couche d'oxyde par-dessus ladite couche de silicium, à prévoir une électrode de grille sur ladite couche de silicium, dégagée de ladite partie, à étendre une plaque de champ par-dessus ladite partie sur ladite couche d'oxyde, et à court-circuiter ladite électrode de grille et ladite plaque de champ.
